# FASCICULE DE BREVET EUROPEEN

(11) **EP 1 331 663 B1**
(45) Date de publication et mention de la délivrance du brevet: **05.11.2008**
(21) Numéro de dépôt: 03290087.0
(22) Date de dépôt: 14.01.2003
(51) Int. Cl.: H01L 21/762, H01L 21/20

(54) **Procédé de clivage de couches d'une tranche de matériau**
Trennverfahren von Schichten eines Scheibenmaterials
Method for cleaving layers of a wafer material

(30) Priorité: 16.01.2002 FR 0200475
(43) Date de publication de la demande: 30.07.2003
(73) Titulaire: S.O.I.Tec Silicon on Insulator Technologies, 38190 Bernin (FR)
(72) Inventeur: Schwarzenbach, Walter, 38330 Saint Nazaire les Eymes (FR); Maleville, Christophe, 38660 La Terrasse (FR)
(74) Mandataire: Le Forestier, Eric

(56) Documents cités:
- EP-A- 0 533 551
- EP-A- 0 926 713
- EP-A- 0 948 032
- EP-A- 0 961 312
- EP-A- 1 045 448

## Description

La présente invention concerne de manière générale le traitement des matériaux, et plus particulièrement de substrats pour l'électronique, l'optique ou l'optoélectronique.

Plus précisément, l'invention concerne un procédé de clivage de deux couches d'un wafer selon une surface de fragilisation définie entre les deux couches, le procédé comprenant un recuit thermique de clivage du wafer comprenant lesdites couches.

On connaît déjà des procédés du type mentionné ci-dessus.

En particulier, il est connu d'appliquer de tels procédés connus pour réaliser le clivage de deux couches de matériau provenant d'un même substrat, entre lesquelles on a préalablement défini une surface de fragilisation par implantation d'espèces dans le substrat.

Les espèces implantées peuvent être des ions ou des atomes. Il est ainsi connu d'implanter un substrat d'un matériau semiconducteur tel que le silicium avec une espèce telle que l'hydrogène ou l'hélium.

Et la surface de fragilisation est déterminée en fonction de la nature du matériau, de la nature des espèces implantées et de l'énergie d'implantation (cette surface de fragilisation étant typiquement un plan parallèle à la face d'implantation du substrat).

Il est également possible de réaliser la surface de fragilisation par tout autre moyen connu en soi, par exemple en construisant une région intermédiaire de matériau poreux entre deux régions de matériau dense, en constituant une couche d'oxyde enterrée dans un substrat (par exemple un substrat de type SOI), ou encore en effectuant un collage de deux couches, la zone de collage correspondant alors à la surface de fragilisation.

Un tel clivage de deux couches séparées par une surface de fragilisation peut être mis en oeuvre pour réaliser des couches minces (dont l'épaisseur peut être comprise entre une fraction de micron et plusieurs microns), comme cela est décrit par exemple dans le document FR 2 681 472.

Ce document décrit en effet un procédé connu sous le nom générique de SMARTCUT®, qui a pour but de fabriquer des structures de type SOI (Silicon On Insulator selon la terminologie anglo-saxonne répandue). Les étapes majeures de ce procédé sont les suivantes :
- Oxydation d'une plaque dite supérieure de silicium, pour créer une couche d'oxyde (qui correspond à la couche d'oxyde enterré de la structure SOI),
- Implantation ionique d'hydrogène dans cette plaque supérieure afin de créer la surface de fragilisation, et de délimiter par cette surface d'une part la structure SOI (se trouvant du côté de l'oxyde enterré), et d'autre part un reliquat de silicium,
- Collage de la plaque supérieure sur une plaque support (qui peut être réalisée en silicium, mais également dans un autre matériau),
- Recuit de clivage et de décollement, afin de :
   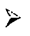 cliver d'une part une structure SOI comprenant la plaque support, la couche d'oxyde enterrée et la couche de silicium située entre l'oxyde enterré et la surface de fragilisation, et d'autre part le reliquat de silicium situé de l'autre côté de la surface de fragilisation. On précise qu'au terme du clivage des forces de cohésion peuvent subsister entre les deux couches, qui restent ainsi solidaires l'une de l'autre,
   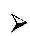 et décoller les deux couches, c'est à dire les disjoindre physiquement, au-delà du clivage,
- Traitement complémentaire destiné à réduire la rugosité de la surface du SOI issue du clivage et du décollement.

On désignera dans la suite de ce texte les structures à décoller et les couches qui les constituent et que l'on décolle par le terme générique de « wafer », qui correspond au terme français de « tranche ».

L'état de surface des wafers est un facteur extrêmement important, des spécifications très sévères étant imposées en vue de l'utilisation ultérieure des wafers issus du décollement, par exemple pour constituer des composants pour l'électronique, l'optique ou l'optoélectronique.

Cet état de surface est notamment caractérisé par la rugosité de surface des wafers issus du décollement.

Il est ainsi courant de trouver des spécifications de rugosité ne devant pas dépasser 5 Angströms en valeur rms (correspondant à l'acronyme anglo-saxon « root mean square »)

Les mesures de rugosité sont généralement effectuées grâce à un microscope à force atomique (AFM selon l'acronyme qui correspond à l'appellation anglo-saxonne de Atomic Force Microscope).

Avec ce type d'appareil, la rugosité est mesurée sur des surfaces balayées par la pointe du microscope AFM, allant de 1x1 µm² à 10x10 µm² et plus rarement 50x50 µm², voire 100x100 µm².

On précise également qu'il est possible de mesurer la rugosité de surface par d'autres méthodes, en particulier par le biais d'une mesure de « haze » selon la terminologie anglo-saxonne répandue. Cette méthode présente notamment l'avantage de permettre de caractériser rapidement l'uniformité de la rugosité sur toute une surface.

Ce haze, mesuré en ppm, est issu d'une méthode utilisant les propriétés de réflectivité optique de la surface à caractériser, et correspond à un « bruit de fond » optique diffusé par la surface, en raison de sa micro-rugosité.

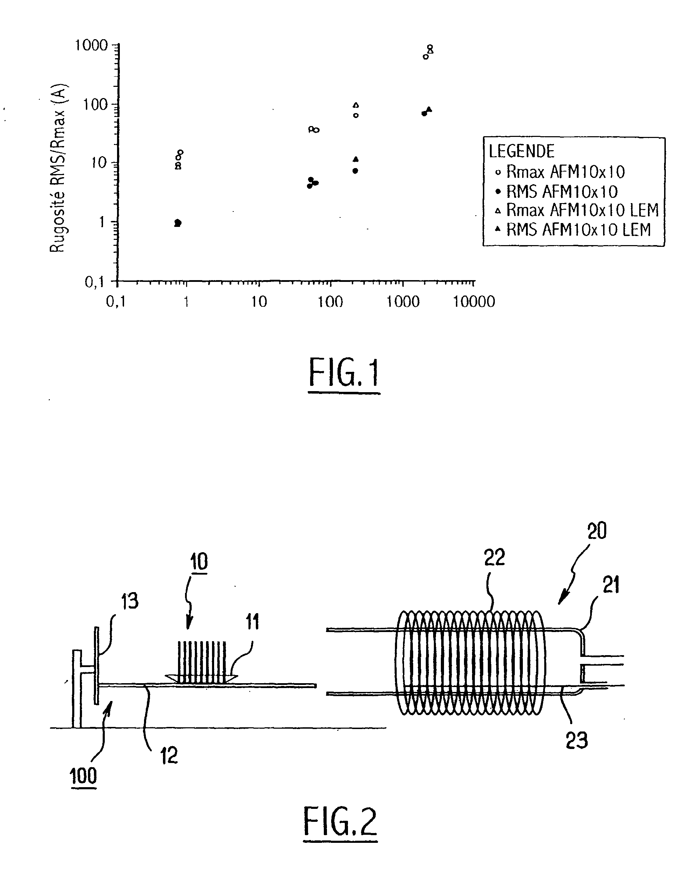

Un exemple de lien entre le haze et la rugosité est représenté, dans le cas de la surface d'un SOI, sur la figure 1.

On précise que les mesures de haze qui seront exposées dans ce texte, sont effectuées selon le même protocole et par le même dispositif, en l'occurrence par un instrument de type KLA Tencor Surfscan SPI (marque déposée).

On précise également que le procédé de type SMARTCUT® peut également être mis en oeuvre pour constituer des structures autres que des SOI, par exemple des SOA (Silicon On Anything selon la terminologie anglo-saxonne répandue : silicium sur un matériau quelconque), ou même des AOA (Anything On Anything selon la terminologie anglo-saxonne répandue : matériau quelconque sur un matériau quelconque).

Les recuits de clivage et de décollement sont classiquement mis en oeuvre dans des fours de recuits dont la configuration est illustrée sur la figure 2. De tels fours peuvent traiter simultanément une pluralité de wafers.

La figure 2 montre ainsi une pluralité de wafers 10 disposés sur un réceptacle 11 tel qu'une nacelle en quartz, les wafers étant alignés parallèlement les uns aux autres.

La nacelle 11 est elle-même placée sur une pelle 12, fixée à une porte 13 d'obturation de la gueule du four.

L'ensemble 100 formé par la porte 13, la pelle 12 et la nacelle et les wafers portés par la pelle est mobile par rapport à une structure de four 20, qui comprend un tube de process en quartz 21 autour duquel est enroulé un élément chauffant 22.

Une canne pyrométrique 23 équipée de thermocouples est également prévue.

Le four de la figure 2 est représenté en position ouverte.

En position fermée, l'ensemble 100 est engagé dans la structure de four 20, la porte 13 obstruant la gueule du four.

A l'intérieur de chaque wafer à décoller, les deux couches constituant le wafer se font face de sorte que les surfaces utiles pour lesquelles on souhaite contrôler de manière extrêmement précise l'état de surface sont placées face à face.

Il est donc particulièrement important de prendre des mesures pour assurer un état de surface (notamment rugosité) le meilleur possible pour ces surfaces utiles.

Reprenant l'état de la technique illustré sur la figure 2, on dispose ainsi les wafers à décoller verticalement.

De la sorte, on prévient les mouvements des deux couches de chaque wafer à décoller qui ne bougent pas l'une par rapport à l'autre (notamment à l'issue du décollement, lorsque l'on retire les couches décollées du four).

Un tel mouvement relatif des deux couches risquerait en effet de produire des rayures sur les faces des couches décollées.

Et il est également très important que l'état de surface - et notamment la rugosité - de ces couches soit aussi homogène que possible, à la surface de la couche.

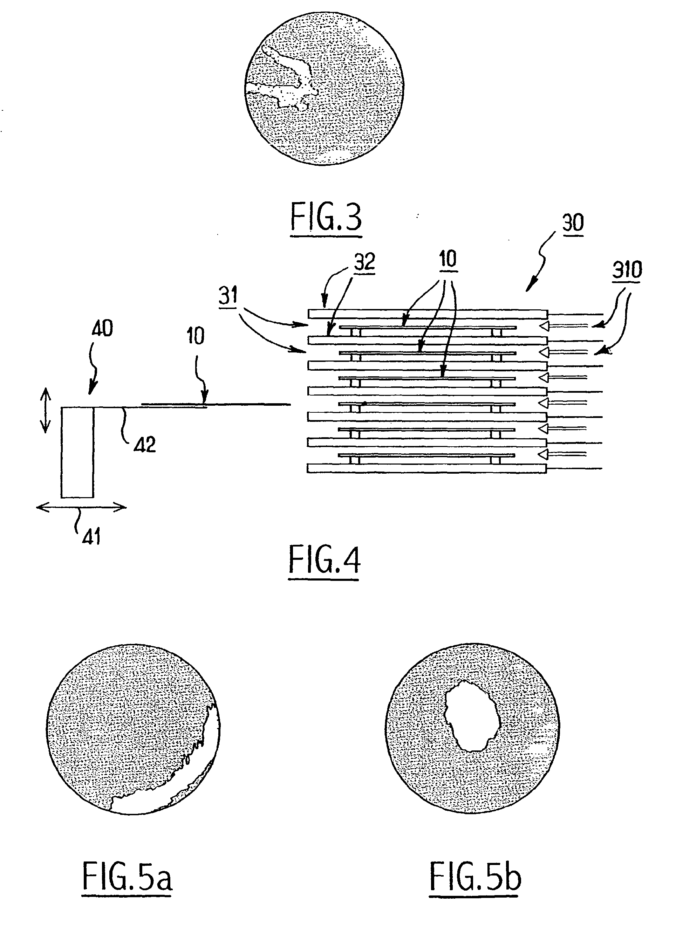

La figure 3 illustre la rugosité de surface d'un wafer SOI après décollement suite à un recuit de clivage réalisé de manière classique dans un four de recuit tel que représenté sur la figure 2.

La rugosité est représentée au travers d'une mesure de haze.

Cette figure illustre une dissymétrie de la rugosité du SOI, qui correspond à un haze moins élevé sur la partie du SOI située dans la partie basse du four (l'encoche - dite « notch » - du SOI qui est placée en bas lors du recuit étant située sur la figure à « 9 heures », à gauche de la figure 3).

Il apparaît ainsi que si les recuits de décollement connus permettent effectivement d'éviter les mouvements pouvant conduire à la formation de rayures, ils favorisent les inhomogénéités de rugosité à la surface des couches issues du décollement.

Ceci constitue un inconvénient, auquel l'invention se propose de répondre.

Le document EP 948032 décrit un procédé de clivage de deux couches d'un wafer en disponant ledit wafer verticalement lors du clivage. Les documents EP 1 045 448 et EP 926 713 décrivent un recuit thermique d'un wafer en disponant ledit wafer horizontalement lors du recuit thermique.

Afin d'atteindre ce but, l'invention propose un procédé de clivage de deux couches d'un wafer selon une surface de fragilisation définie entre les deux couches, le procédé comprenant un recuit thermique de clivage du wafer comprenant lesdites couches, caractérisé en ce que lors du recuit ledit wafer est disposé sensiblement horizontalement.

Des aspects préférés, mais non limitatifs de ce procédé sont les suivants :
- on place la structure dans un logement entre deux électrodes chauffantes,
- on prévoit des moyens pour réaliser une manutention des couches de matériau dans une position horizontale,
- ladite manutention est réalisée individuellement, pour chaque wafer,
- ladite manutention est réalisée individuellement, pour chaque couche,
- on recuit simultanément une pluralité de wafers, chaque wafer étant placé entre deux électrodes chauffantes.

Et l'invention propose selon un autre aspect l'application d'un procédé tel que mentionné ci-dessus pour cliver deux couches de matériau délimitées par une surface de fragilisation, ladite surface de fragilisation ayant été réalisée dans le cadre d'un procédé de type SMARTCUT®.

Des aspects préférés, mais non limitatifs d'une telle application sont les suivants :
- les deux couches de matériau comprennent une couche de silicium,
- les deux couches de matériau sont deux couches de silicium, une des deux couches correspondant à la couche superficielle d'un SOI, l'autre couche correspondant à un reliquat de silicium.

Enfin, l'invention propose un dispositif de recuit de clivage d'un wafer, comprenant un four apte à recevoir au moins un wafer, caractérisé en ce que chaque wafer est reçu dans un logement en position horizontale, de sorte que le recuit de clivage est réalisé tandis que le wafer est en position horizontale.

Dans une variante, le dispositif comprend également des moyens de manutention des wafers et/ou des couches qui constituent lesdits wafers, à l'horizontale.

D'autres aspects, buts et avantages de l'invention apparaîtront mieux à la lecture de la description suivante d'une forme de réalisation de l'invention, faite en référence aux dessins annexés sur lesquels, outre les figures 1 à 3 qui ont déjà été commentées en référence à l'état de la technique :
- la figure 4 représente schématiquement une installation de recuit de clivage permettant de mettre en oeuvre l'invention,
- les figures 5a et 5b représentent respectivement des répartitions spatiales de haze à la surface de deux SOI, le SOI de la figure 5a ayant subi un recuit de clivage dans un four habituellement utilisé à cet effet selon l'état de la technique, le SOI de la figure 5b ayant quant à lui subi un recuit de clivage en étant disposé horizontalement dans son four de recuit, selon l'invention.

En référence maintenant à la figure 4, on a représenté un four 30 mis en oeuvre selon l'invention pour réaliser un recuit de clivage d'une pluralité de wafers 10.

On remarque tout d'abord que dans ce four, les wafers ne sont pas disposés verticalement comme dans l'état de la technique, mais horizontalement.

Plus précisément, chaque wafer 10 est placé dans un logement 31 défini par deux électrodes voisines 32 d'une pluralité d'électrodes du four 30.

Et ces électrodes 32 s'étendant parallèlement les unes aux autres selon une direction horizontale, elles définissent des logements 31 horizontaux, pouvant chacun recevoir un wafer 10 à décoller, en position horizontale.

Le chauffage est assuré par un gaz qui pénètre dans les logements 31 par des entrées respectives 310, ce gaz étant lui-même échauffé par les électrodes délimitant chaque logement.

On précise que le gaz « chauffant » peut servir uniquement à diffuser la chaleur issue des électrodes sur les wafers. Il peut également avoir été préchauffé, avant son introduction dans le four.

La configuration spécifique du four « horizontal » qui est utilisé selon l'invention pour réaliser un recuit de clivage permet d'éliminer les effets de gradient de température dans le four, entre les parties haute et basse du four.

Ceci conduit à améliorer sensiblement l'homogénéité de la rugosité à la surface des couches, après leur décollement.

A cet égard, on a illustré sur les figures 5a et 5b l'effet de l'utilisation selon l'invention d'un four « horizontal » pour un recuit de clivage.

La figure 5a représente la répartition de haze à la surface d'un SOI décollé suite à un recuit de clivage classique, dans un four « vertical » tel qu'illustré sur la figure 2.

Cette figure, analogue à la figure 3, fait apparaître une « zone dense » qui correspond dans la partie inférieure droite de la couche, à une inhomogénéité de rugosité.

La figure 5b, au contraire, montre une rugosité parfaitement symétrique d'un SOI décollé suite à un recuit de clivage effectué dans un four « horizontal », selon l'invention.

Et cette rugosité ne présente plus la caractéristique de « zone dense » observée dans le cas du SOI de la figure 5a.

Il apparaît ainsi que l'utilisation selon l'invention d'un four « horizontal » permet de s'affranchir des problèmes de « zone dense » de rugosité mentionnés ci-dessus à propos des recuits de clivage de l'état de la technique.

On précise par ailleurs que des dispositions sont également prévues dans le cas du four « horizontal » de la figure 4, pour éviter tout mouvement des couches qui pourrait générer des rayures - notamment lors du déchargement des couches décollées hors du four.

A cet égard, on a représenté sur la figure 4 un robot de manutention 40, qui est apte à :
- saisir individuellement :
   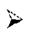 les wafers, pour les introduire dans le four, et
   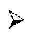 les couches décollées, pour les sortir du four après le clivage. On précise qu'il est également envisageable de ne procéder qu'à un recuit de clivage sans achever le décollement des wafers, ce décollement pouvant être achevé hors du four après le déchargement par le robot 40 des wafers clivés (par exemple par une action mécanique),
- et à se déplacer selon une direction 41 (ainsi que selon une direction « verticale » qui lui est perpendiculaire), pour effectuer les chargements et déchargements nécessaires (en traitant chaque wafer individuellement)
   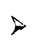 on précise que dans le cas où on réalise effectivement le décollement des deux couches du wafer lors du recuit, les deux couches du wafer qui se trouvent décollées peuvent être déchargées séparément par le robot. A cet égard, le bras 42 du robot qui saisit les wafers et/ou les couches peut comprendre un moyen tel qu'une ventouse pouvant être mise en dépression sélectivement, ou encore un moyen manipulant les tranches par leur bord pour saisir chaque couche indépendamment de la couche dont elle a été décollée, ou bien encore un moyen permettant de manipuler les deux couches simultanément en vue de leur décollement à l'extérieur du four.

Lors de ces manutentions par le robot 40, les wafers et couches demeurent horizontaux.

On précise que si les exemples ci-dessus ont été décrits en référence à un clivage permettant de générer un SOI, en particulier par un procédé du type SMARTCUT®, l'invention s'applique au clivage de toute structure comportant une surface de fragilisation permettant de délimiter des couches.

## Revendications

1. Procédé de clivage de deux couches d'un wafer selon une surface de fragilisation définie entre les deux couches, le procédé comprenant un recuit thermique de clivage du wafer comprenant lesdites couches, **caractérisé en ce que** iors du recuit ledit wafer est disposé sensiblement horizontalement.

2. Procédé selon la revendication précédente, **caractérisé en ce que** on place la structure dans un logement (31) entre deux électrodes chauffantes (32).

3. Procédé selon l'une des revendications précédentes, **caractérisé en ce que** l'on prévoit des moyens (40) pour réaliser une manutention des couches de matériau dans une position horizontale.

4. Procédé selon la revendication précédente, **caractérisé en ce que** ladite manutention est réalisée individuellement, pour chaque wafer.

5. Procédé selon l'une des deux revendications précédentes, **caractérisé en ce que** ladite manutention est réalisée individuellement, pour chaque couche.

6. Procédé selon l'une des revendications précédentes, **caractérisé en ce que** l'on recuit simultanément une pluralité de wafers, chaque wafer étant placé entre deux électrodes chauffantes.

7. Application d'un procédé selon l'une des revendications précédente(s) pour cliver deux couches de matériau délimitées par une surface de fragilisation, ladite surface de fragilisation ayant été réalisée dans le cadre d'un procédé de type SMARTCUT^{®}.

8. Application selon la revendication précédente **caractérisée en ce que** les deux couches de matériau comprennent une couche de silicium.

9. Application selon l'une des deux revendications précédentes **caractérisée en ce que** les deux couches de matériau sont deux couches de silicium, une des deux couches correspondant à ia couche superficielle d'un SOI, l'autre couche correspondant à un reliquat de silicium.

10. Dispositif de recuit de clivage d'un wafer, comprenant un four (30) apte à recevoir au moins un wafer, **caractérisé en ce que** chaque wafer est reçu dans un logement en position horizontale, de sorte que le recuit de clivage est réalisé tandis que le wafer est en position horizontale.

11. Dispositif selon la revendication précédente **caractérisée en ce que** le dispositif comprend également des moyens (40) de manutention des wafers et/ou des couches qui constituent lesdits wafers, à l'horizontale.

## Claims

1. Method for cleaving two layers of a wafer along a weakened surface defined between the two layers, the method comprising a thermal annealing for cleaving the wafer comprising said layers, **characterized in that** during annealing said wafer is positioned approximately horizontally.

2. Method according to the preceding claim, **characterized in that** the structure is placed in a housing (31) between two heating electrodes (32).

3. Method according to one of the preceding claims, **characterized in that** means (40) are provided to manipulate layers of material in a horizontal position.

4. Method according to the preceding claim, **characterized in that** said manipulation is carried out individually for each wafer.

5. Method according to one of the two preceding claims, **characterized in that** said manipulation is carried out individually for each layer.

6. Method according to one of the preceding claims, **characterized in that** a plurality of wafers is simultaneously annealed, each wafer being placed between two heating electrodes.

7. Application of a method according to one of the preceding claims to cleave two layers of material delimited by a weakened surface, said weakened surface having been produced in the context of a Smartcut^{®} procedure.

8. Application according to the preceding claim, **characterized in that** the two layers of material include a silicon layer.

9. Application according to one of the two preceding claims, **characterized in that** the two layers of material are two silicon layers, one of the two layers corresponding to the surface layer of an SOI, the other layer corresponding to a remainder of silicon.

10. Annealing device for cleaving a wafer, comprising a furnace (30) capable of receiving at least one wafer, **characterized in that** each wafer is received in a housing in a horizontal position, such that the annealing for cleaving is carried out when the wafer is in a horizontal position.

11. Device according to the preceding claim, **characterized in that** the device also comprises means (40) for manipulating wafers and/or the layers that constitute said wafers horizontally.

## Patentansprüche

1. Verfahren zur Spaltung zweier Schichten eines Wafers entlang einer zwischen den beiden Schichten festgelegten Sollbruchfläche, wobei das Verfahren ein thermisches Glühen zur Spaltung des die Schichten umfassenden Wafers umfasst, **dadurch gekennzeichnet, dass**
der Wafer während des Glühens zur Spaltung im wesentlichen horizontal angeordnet ist.

2. Verfahren gemäß des vorherigen Anspruchs, **dadurch gekennzeichnet dass**
der Wafer in einer Aufnahme (31) zwischen zwei Heizelektroden (32) angeordnet wird.

3. Verfahren nach einem der vorherigen Ansprüche, **dadurch gekennzeichnet, dass**
Mittel (40) vorgesehen sind, um eine Beförderung der Materialschichten in eine horizontale Position auszuführen.

4. Verfahren gemäß des vorherigen Anspruchs, **dadurch gekennzeichnet dass**
die besagte Beförderung für jeden Wafer einzeln erfolgt.

5. Verfahren nach einem der beiden vorherigen Ansprüche, **dadurch gekennzeichnet, dass**
die besagte Beförderung für jede Schicht einzeln erfolgt.

6. Verfahren nach einem der vorherigen Ansprüche **dadurch gekennzeichnet, dass**
gleichzeitig eine Mehrzahl von Wafern geglüht wird, wobei jeder Wafer zwischen zwei Heizelektroden positioniert ist.

7. Verwendung eines Verfahrens gemäß einem der vorherigen Ansprüche zur Spaltung von zwei durch eine Sollbruchfläche von einander abgegrenzte Materialschichten, wobei die Sollbruchfläche mittels eines Verfahrens des Typs SMARTCUT^{®} erzeugt wurde.

8. Verwendung eines Verfahrens gemäß einem der vorherigen Ansprüche, **dadurch gekennzeichnet, dass**
die beiden Materialschichten eine Schicht Silizium umfassen.

9. Verwendung eines Verfahrens gemäß einem der beiden vorherigen Ansprüche, **dadurch gekennzeichnet, dass**
beide Materialschichten Schichten aus Silizium sind,
wobei eine der beiden Schichten einer Oberflächenschicht eines SOI und die andere Schicht einem Siliziumrest entspricht.

10. Vorrichtung zum Glühen zur Spaltung eines Wafers, die einen Ofen (30) umfasst, der dazu ausgelegt ist, zumindest einen Wafer aufzunehmen,
**dadurch gekennzeichnet, dass**
jeder Wafer in einer Aufnahme in horizontaler Position aufgenommen wird und das Glühen zur Spaltung ausgeführt wird, während sich der Wafer in horizontaler Position befindet.

11. Vorrichtung gemäß des vorherigen Anspruchs, **dadurch gekennzeichnet, dass**
die Vorrichtung Mittel (40) zur Beförderung der Wafer und/oder der die Wafer bildenden Schichten in die Horizontale umfasst.
